# EUROPEAN PATENT SPECIFICATION

(11) **EP 3 342 895 B1**
(45) Date of publication and mention of the grant of the patent: **28.07.2021**
(21) Application number: 16841737.6
(22) Date of filing: 26.08.2016
(51) Int. Cl.: C22C 38/40, C22C 38/06, C22C 38/00, C22C 38/28, C21D 6/00, C22C 38/04, C22C 38/20, C22C 38/24, C22C 38/34, C21D 1/76, C25F 1/06, C21D 1/74, C21D 8/02, C21D 8/04, C21D 9/46, C21D 9/48, C21D 1/26, H01L 31/0392, C22C 38/22, C22C 38/26, C22C 38/02

(54) **AL-CONTAINING FERRITIC STAINLESS STEEL AND METHOD FOR MANUFACTURING SAME**
AL-HALTIGER FERRITISCHER EDELSTAHL UND VERFAHREN ZUR HERSTELLUNG DAVON
ACIER INOXYDABLE FERRITIQUE CONTENANT D'AL ET UN PROCÉDÉ POUR SA FABRICATION

(30) Priority: 28.08.2015 JP 2015169683
(43) Date of publication of application: 04.07.2018
(73) Proprietor: NIPPON STEEL Stainless Steel Corporation, Tokyo 100-0005 (JP)
(72) Inventor: HATANO, Masaharu, Tokyo 100-0004 (JP); SUGEOI, Mitsuki, Tokyo 100-0004 (JP); UCHIDA, Toshihiko, Tokyo 100-0004 (JP); YAMAGISHI, Akihito, Tokyo 1000004 (JP)
(74) Representative: Vossius & Partner Patentanwälte Rechtsanwälte mbB
(86) International application number: PCT/JP2016/075042
(87) International publication number: WO 2017/038705

(56) References cited:
- EP-A1- 0 810 295
- EP-A1- 1 257 414
- EP-A1- 2 650 059
- EP-A1- 3 176 277
- WO-A1-2014/050011
- JP-A- H04 224 658
- JP-A- H05 202 449
- JP-A- 2010 222 638
- JP-A- 2011 032 524
- JP-A- 2011 162 863
- JP-A- 2013 199 674
- JP-A- 2014 218 728
- JP-A- 2016 030 855

## Description

### Technical Field

The present invention relates to Al-containing ferritic stainless steel excellent in sulfide corrosion resistance without relying on surface treatment such as coating or plating and a method for production thereof. The Al-containing ferritic stainless steel of the present invention can be used in environments exposed to sulfide atmospheres such as oil burning or combustion environments, for example, film-forming processes including heat treatment in which the steel is exposed to hydrogen sulfide gas. In particular, the Al-containing ferritic stainless steel of the present invention is optimal for the substrates of the compound-based thin film solar cells to which attention for solar power generation has been attracted in recent years.

### Background Art

In the past, ceramics and glass with their small thermal expansion coefficients have been used as materials for substrates of compound-based thin film solar cells, but use of stainless steel excellent in heat resistance for substrate materials has also been studied.

For example, PLTs 1 and 2 disclose insulating materials comprising smooth stainless steel sheets the surfaces of which are covered with alumina or silicon oxide or silicon nitride films. For the base materials of the stainless steel, general-purpose ferritic stainless steel SUS430 (17Cr steel) has been used. Further, PLT 3 discloses a stainless steel material with good film-formability with a surface wherein both surface roughness parameters Rz and Rsk are defined. For the base material of the stainless steel, SUS430J1L to which Nb and Cu have been added (18Cr-0.4Cu-0.4Nb) and general-purpose austenite-based stainless steel SUS304 (18Cr-8Ni) have been used.

In recent years, solar power generation has developed into one of the major sources of energy for taking the place of fossil fuels. The technology for solar cells is accelarated. Among these, CIS-based thin film or other compound-type solar cells are expected to be popularized as solar cells achieving both low cost and high efficiency in the future.
Compound-based thin film solar cells are produced, In an example of the method for production thereof, by forming an insulation layer on a substrate, forming a first electrode layer comprising an Mo layer on the insulation layer, covering the insulation layer with a chalcopyrite type compound layer as a light-absorbing layer, and further forming a second electrode layer. Here, a chalcopyrite type compound is a five-element type alloy which is represented by Cu-In-Ga-Se-S-based (below, CIS-based) alloy.

In the past, glass, which is an insulator and has a small thermal expansion coefficient, has been widely used for solar cell substrates. However, glass is brittle and heavy, so it is not easy to mass produce solar cell substrates comprising glass with light- absorbing layers formed on the surface thereof. Therefore, in recent years, in view of reduction of weight and mass production, solar cell substrates using stainless steel, which is excellent in heat resistance and balance of strength and ductility, are developed.

For example, PLT 4 discloses a method for producing a solar cell substrate material comprising forming an insulation film disclosed in PLT 1 or 2 on 0.2 mm or less stainless steel foil and forming back surface electrodes comprising the Mo layer and a light-absorbing layer comprising a Cu(In₁₋ₓGaₓ)Se₂ film on the insulating substrate. For the base material of the stainless steel foil, SUS430, SUS444 (18Cr-2Mo), and SUS447J1 (30Cr-2Mo) are being used.

Further, PLTs 5 and 6 disclose electrode substrates for CIS solar cell having structures, in which Cu-covered steel sheets comprises Cu covering layers and the above Mo electrodes and light-absorbing layers comprising Cu(In₁₋ₓGaₓ)Se₂ films formed on the Cu covering layers. Here, it is specified that the Cu-covered steel sheets are formed from ferritic stainless steel comprising C: 0.0001 to 0.15%, Si: 0.001 to 1.2%, Mn: 0.001 to 1.2%, P: 0.001 to 0.04%, S: 0.0005 to 0.03%, Ni: 0 to 0.6%, Cr: 11.5 to 32.0%, Mo: 0 to 2.5%, Cu: 0 to 1.0%, Nb: 0 to 1.0%, Ti: 0 to 1.0%, Al: 0 to 0.2%, N: 0 to 0.025%, B: 0 to 0.01%, V: 0 to 0.5%, W: 0 to 0.3%, and the total amount of Ca, Mg, Y, and REM (rare earth metal): 0 to 0.1% and having a balance of Fe and unavoidable impurities. However, the ferritic stainless steels used in the examples are limited to SUS430.

Recently, PLT 7 has disclosed a stainless steel material the surface of which an insulation film with a good heat resistance is formed and a method for production thereof. The stainless steel used as the base material comprises C: 0.0001 to 0.15%, Si: 0.001 to 1.2%, Mn: 0.001 to 2.0%, P: 0.001 to 0.05%, S: 0.0005 to 0.03%, Ni: 0 to 2.0%, Cu: 0 to 1.0%, Cr: 11.0 to 32.0%, Mo: 0 to 3.0%, Al: 1.0 to 6.0%, Nb: 0 to 1.0%, Ti: 0 to 1.0%, N: 0 to 0.025%, B: 0 to 0.01%, V: 0 to 0.5%, W: 0 to 0.3%, and the total amount of Ca, Mg, Y, and REM (rare earth metal): 0 to 0.1% and has a balance of Fe and unavoidable impurities, and the stainless steel disclosed in PLT 7 is characterized by a mixture layer comprising NiO and NiFe₂₂O₄ with a thickness 1.0 µm or more being formed on the surface thereof via an Al oxide layer. Here, the NiO etc. mixed layer and the Al oxide layer are prepared by coating the steel with Ni by electroplating, then heat treating it in the atmosphere to cause the formation of an Al oxide layer at the interface of the steel and Ni plating and cause the Ni plating to transform to an oxide layer.

PLTs 8 and 9 disclose a process for forming a compound-based thin film solar cell wherein the precursors of the light-absorbing layer of Cu, In, and Ga are formed on a substrate by sputtering, then the film is converted to a CIS-based compound thin film by exposing the film to a highly corrosive gas atmosphere of hydrogen sulfide (H₂S) in a heat treatment step (sulfide step). To use stainless steel as a substrate without relying on surface treatment such as coating or plating, securing sulfide corrosion resistance at the back side of the device where the metal surface is exposed is an important matter. Therefore, PLT 9 studies the application of JFE18-3USR that is ferritic stainless steel substrate containing 3.4% of A1. WO 2014/050011 A1, EP 2650059 A1 and EP 3176277 A1 disclose ferritic stainless steels.

### Citation List

### Patent Literature

PLT 1: Japanese Patent Publication No. 6-299347A
PLT 2: Japanese Patent Publication No. 6-306611A
PLT 3: Japanese Patent Publication No. 2011-204723A
PLT 4: Japanese Patent Publication No. 2012-169479A
PLT 5: Japanese Patent Publication No. 2012-59854A
PLT 6: Japanese Patent Publication No. 2012-59855A
PLT 7: Japanese Patent Publication No. 2012-214886A
PLT 8: Japanese Patent No. 3249407B2
PLT 9: Japanese Patent No. 3249408B2

### Summary of Invention

### Technical Problem

As disclosed in PLT 8, to develop the popularization of CIS-based compound-based thin film solar cells as the main type of solar power generation in the future, raising the sulfide corrosion resistance of the stainless steel sheet for substrate and improving the productivity by eliminating coating and other troublesome surface treatment are important matters. Regarding this point, the arts disclosed in PLTs 1 to 7 are limited to only application of stainless steel obtained by coating or plating, while the art disclosed in PLT 9 is limited to only application of 3.4% Al-containing ferritic stainless steel substrates.

Therefore, the technical problem which the present invention is intended to solve is to provide Al-containing ferritic stainless steel sheet provided with sulfide corrosion resistance without relying on surface treatment such as coating or plating or addition of 3% or more of Al and a method for production thereof.

### Solution to Problem

The inventors researched to solve the above problem by carrying out intensive experiments and studies the surface film and sulfide corrosion resistance of Al-containing ferritic stainless steel and thereby completed the present invention. Below, the findings obtained in the present invention will be explained.
(a) High purity ferritic stainless steel such as SUS430LX and SUS430J1L is corroded by sulfide corrosion leading to sloughing of the steel base material when being exposed to an atmosphere containing several percent of hydrogen sulfide gas at a high temperature of 400 to 700°C for 0.5 to 2 hours or so. Such sulfide corrosion occurs because Fe and Cr which are the component elements of stainless steel react with the S in the atmospheric gas to form FeS₂ and FeCr₂S₄ and corrode the steel.
(b) In the case of ferritic stainless steel containing a 3% or more amount of Al corresponding to the specifications of SUH21 disclosed in PLT 9, a continuous film of Al₂O₃ is formed at a high temperature, so the above-mentioned sulfide corrosion is alleviated. On the other hand, in the case of less than 3% Al-containing ferritic stainless steel, the sulfide corrosion resistance is affected by the composition of the film on the surface. Usually, after pickling or polishing the surface of ferritic stainless steel, a thin passivation film of Fe and Cr with thickness of several nm is formed on the surface thereof. Sulfide corrosion easily occurs when a passivation film mainly comprising Fe and Cr is formed on the surface. On the other hand, the inventors obtained the new knowledge that when raising the concentration of Al in the surface film to reduce the concentrations of Fe and Cr in advance and also raising the amount of Mg and the total content of the amounts of Mg and Ga, sulfide corrosion can be remarkably suppressed.
(c) The inventors found that when the amount of addition of Al is less than 3%, it is effective to add Mg and Ga as trace elements instead of increasing the content of Al in the stainless steel in order to raise the amounts of Al and Mg in the above surface film.
   Mg and Ga are surface active elements and selectively concentrate at the surface in a low oxygen atmosphere even if added in trace amounts. Furthermore, Mg forms oxides and effectively acts to suppress the oxidation of Fe and Cr and to form a surface film containing Al, Si, and Ti. In particular, The inventors found that when the total content of the amount of Mg and the amount of Ga is over 0.002%, the above-mentioned effect becomes remarkable.
(d) Furthermore, The inventors found on the basis of detailed surface analysis of 2%Al-containing ferritic stainless steel that by reducing the amount of S detected from the surface film to the stainless steel base material, the sulfide corrosion resistance is further improved.
(e) To form the surface film, it is effective to bright anneal the steel in a low dew point atmosphere containing hydrogen gas after cold working. In that case as well, adding the above Mg and Ga in trace amounts is effective for forming the surface film.
(f) Furthermore, in order to reduce the amount of S from the surface film to the stainless steel base material to obtain a greater sulfide corrosion resistance, after the above bright annealing, it is effective to treat the steel by nitric acid electrolytic pickling.

The subject-matter of the present invention completed based on the discoveries of the above (a) to (f) is as defined in the claims.
Below, the aspects of the invention will sometimes be referred to as "the present invention".

### Advantageous Effects of Invention

The present invention exhibits the remarkable effect of enabling the production of ferritic stainless steel provided with sulfide corrosion resistance without relying on surface treatment such as coating or plating or addition of 3% or more of Al. According to the present invention, for example, it is possible to obtain Al-containing ferritic stainless steel suitable for the substrate of a CIS-based thin film solar cell produced accompanied with heat treatment involving exposure to hydrogen sulfide gas in the film forming process etc.

### Description of Embodiments

Below, requirements of the present invention will be explained in detail. Note that the indications "%" of the contents of these elements mean "mass%".

(I) The reasons for limitation of the components will be explained below:
C forms a solid solution or Cr carbides in the ferrite phases to cause a drop in the oxidation resistance and obstruct the formation of a surface film mainly comprising Al. For this reason, the smaller the amount of C the better. The upper limit is made 0.03%. However, excessive reduction leads to increase the refining costs, so the lower limit is preferably made 0.001%. From the viewpoints of the sulfide corrosion resistance and manufacturability, the preferable range is 0.002% to 0.02%.

Si is an element important for securing sulfide corrosion resistance. Si forms a solid solution in an oxide film and concentrates at the interface of the oxide film and steel base material. It suppresses the entry of hydrogen sulfide (H₂S) into the steel and improves the sulfide corrosion resistance. To obtain these effects, the lower limit is preferably made 0.1%. On the other hand, excessive addition invites a drop in the toughness and workability of the steel, so the upper limit is made 2%. From the viewpoints of the sulfide corrosion resistance and basic characteristics, 1.5% or less is preferable. If positively utilizing the effects of Si, 0.3% or more is preferable.

Mn has the effect of suppressing surface oxidation of Fe to promote the formation of a surface film containing Al, Si, and Ti. To obtain these effects, the lower limit is preferably 0.1% or more. On the other hand, excessive addition lowers the oxidation resistance and leads to obstruction of the improvement of the sulfide corrosion resistance, so the upper limit is made 1% or less. In view of positively utilizing the effect of Mn, the content is preferably made 0.2% to 1.0% in range.

Cr is a basic component element in not only corrosion resistance, but also securing formation of the surface film and improvement of the sulfide corrosion resistance. In the present invention, when less than 13%, the targeted sulfide corrosion resistance cannot be sufficiently secured. Therefore, the lower limit is made 13%. However, excessive addition of Cr increases the concentration of Cr in the surface film. Therefore, when the stainless steel being exposed to a high temperature hydrogen sulfide atmosphere, the sulfide corrosion resistance is obstructed and increase in alloy costs is invited. The upper limit is made 21% from the viewpoints of the sulfide corrosion resistance and alloy costs. The preferable range is 15% to 20%, while the more preferable range is 17% to 19%.

P is an element obstructing the manufacturability and weldability. The smaller the content the better, so the upper limit is made 0.05%. However, excessive reduction leads to increase in refining costs, so the lower limit is preferably made to be 0.003%. From the viewpoints of the manufacturability and weldability, the preferable range is 0.005% to 0.04%, more preferably 0.01% to 0.03%.

S is an unavoidable impurity element included in steel and obstructs the improvement of the sulfide corrosion resistance. In particular, the presence of S in the surface film and Mn-based inclusions or solid solution S in the steel act as starting points of fracture of the surface film when exposed to a high temperature hydrogen sulfide atmosphere. Therefore, the lower the amount of S the better, so the upper limit is made 0.01%. However, excessive reduction leads to increase in the costs of the starting materials and refining, so the lower limit is made 0.0001. From the viewpoints of the manufacturability and sulfide corrosion resistance, the preferable range is made 0.0001% to 0.002%, more preferably 0.0002% to 0.001%.

Al is not only a deoxidizing element, but also an added element essential for realizing improvement of the sulfide corrosion resistance by conversion of the surface film. In the present invention, if less than 1.5%, the targeted film composition cannot be realized and sulfide corrosion resistance cannot be obtained. Therefore, the lower limit is made 1.5%. However, addition of 3% or more of Al invites a drop in the toughness or weldability of the steel and obstructs productivity, so is an issue in the rise of alloy costs and in economic efficiency and manufacturability. The upper limit is made 2.5% from the viewpoints of the economic efficiency and manufacturability. It may also be less than 2%. From the viewpoints of the sulfide corrosion resistance and basic properties of the present invention, the preferable range is 1.7% to 2.3%.

Ti not only improves the oxidation resistance through purifying the steel by virtue of the effect thereof as a stabilizing element fixing the C and N, but also improves the sulfide corrosion resistance by virtue of conversion of the film. The lower limit is made 0.03% or more at which these effects are obtained. However, excessive addition leads to increase the alloy costs and rise in the recrystallization temperature with an accompanying drop in the manufacturability, so the upper limit is made 0.5%. From the viewpoints of the alloy costs and manufacturability and the sulfide corrosion resistance, the preferable range is 0.05% to 0.35%. Further, the more preferable range for active utilization of the effect of Ti is 0.1% to 0.25%.

N, like C, obstructs the improvement of the sulfide corrosion resistance. For this reason, the smaller the amount of N the better. The upper limit is made 0.03%. However, excessive reduction leads to increase in the refining costs, so the lower limit is preferably made 0.002%. From the viewpoints of the sulfide corrosion resistance and manufacturability, the preferable range is 0.005% to 0.02%.

In addition to the above basic composition, to raise the sulfide corrosion resistance, Mg is added in a range of 0.0005 to 0.01% and Ga may be added. These elements, as explained above, have the effect of concentrating at the surface to suppress the oxidation of Fe and Cr and promote the formation of a surface film mainly comprising Al. Further, they have the effect of promoting the formation of a surface film having high Si and Ti contents. To obtain these effects, the lower limits of Mg and Ga are made to be 0.0005%. Regarding Mg and Ga, the total content is made over 0.002%. On the other hand, excessive addition causes to increase the refining costs of the steel and obstructs the improvement of the manufacturability and sulfide corrosion resistance, so the upper limits are made Mg: 0.01% and Ga: 0.1%. From the viewpoints of the improvement of the sulfide corrosion resistance and the cost and manufacturability, the contents are preferably made Mg: 0.001 % to 0.008% and Ga: 0.001 % to 0.02% in range. Further, the upper limit of the total content of Mg and Ga is preferably made 0.11%.

Further, the stainless steel of the present invention may further contain, in accordance with need, one or more of Ni: 1% or less, Cu: 1% or less, Mo: 2% or less, Nb: 0.5% or less, V: 0.5% or less, Sn: 0.2% or less, Sb: 0.2% or less, W: 1.0% or less, Zr: 0.5% or less, Co: 0.5% or less, B: 0.005% or less, Ca: 0.005% or less, La: 0.1% or less, Y: 0.1% or less, Hf: 0.1% or less, and REM: 0.1% or less.

Ni, Cu, Mo, Nb, V, W, Sn, Sb, and Co are elements effective for improving the high temperature strength and corrosion resistance of the stainless steel and are added as needed. However, excessive addition leads to increase in alloy costs and obstructs manufacturability, so the upper limits of Ni, Cu, and W are made 1%. Mo is an element effective also for suppressing high temperature deformation due to the drop in the thermal expansion coefficient, so the upper limit is made 2%. The upper limits of Nb, V, and Co are made 0.5%. The upper limits of Sn and Sb are made 0.2% from the viewpoint of the manufacturability. In each element, the more preferable lower limit of the content is made 0.05%.

B and Ca are elements for improving the hot workability and secondary workability and are added in accordance with need. However, excessive addition leads to obstruction of the manufacturability, so the upper limit is made 0.005%. The preferable lower limit is made 0.0001%.

Zr, La, Y, Hf, and REM improve the hot workability and cleanliness of the steel and are elements conventionally deemed effective for improvement of the oxidation resistance, so may be added in accordance with need. However, the sulfide corrosion resistance of the stainless steel of the present invention does not depend on the addition of these elements. If adding these elements, the upper limit of Zr is made 0.5%, while the upper limits of La, Y, Hf, and REM are made respectively 0.1%. The more preferable lower limit of Zr is made 0.01%, while the preferable lower limits of La, Y, Hf, and REM are made 0.001%. Here, "REM" is an element belonging to atomic numbers 57 to 71. For example, it includes Ce, Pr, Nd, etc.

In addition to the elements explained above, impurity elements are contained as far as the effects of the present invention are not harmed. The general impurity elements of the aforementioned P and S as well as also Zn, Bi, Pb, Se, H, Ta, etc. are preferably reduced as much as possible. These elements are controlled in ratios of content to the extent for solving the problems of the present invention. The contents are Zn≤500 ppm, Bi≤100 ppm, Pb≤100 ppm, Se≤100 ppm, H≤100 ppm, and Ta≤500 ppm.

(II) The reasons for limitation of the surface film will be explained below.
The Al-containing ferritic stainless steel of the present invention is characterized by comprising the above-mentioned steel components and further increasing the amount of Mg and the total contents of Mg and Ga to form a surface film mainly comprising Al so that the sulfide corrosion resistance is obtained. The upper limit of the surface film thickness is made to be 100 nm. By conducting bright annealing designed for productivity or at least one of heat treatment and pickling which provide an effect equivalent to the bright annealing, it is preferably made 100 nm or less. The lower limit of the film thickness is made 3 nm or more where the effect on the sulfide corrosion resistance in hydrogen sulfide is exhibited. The preferable range of thickness is 3 to 30 nm.

In view of obtaining sulfide corrosion resistance in H₂S, the composition of the above-mentioned surface film is made to be Al: over 60 at%, Cr: less than 10 at%, Fe: less than 10 at%, and Mg: over 0.5 at% to less than 5 at% with respect to the total amount of all cations other than O, C, and N.

Al concentrates from the inside layer of the surface film to the base iron interface and remarkably suppresses the entry of corrosive gas S into the steel. These effects remarkably appear by making the concentration of Al in the surface film over 60 at%, preferably 70 at% or more, more preferably 80 at% or more. The upper limit of the concentration of Al is not particularly defined, but is preferably made 90 at% in view of the efficiency of bright annealing etc.

Cr and Fe fall due to the formation of the film in which Al is concentrated. It is possible to cause a remarkable reduction in corrosion products comprising compounds of S, Cr, and Fe. These effects are exhibited by reducing the concentrations of Cr and Fe to 10 at% or less. The concentrations are preferably 7 at% or less, more preferably 5 at% or less. The lower limits of the concentrations of Cr and Fe are not particularly defined, but are preferably made 1 at%, more preferably 2 at%, considering the efficiency of bright annealing etc.

Mg is also contained in the above-mentioned surface film and has the effect of improvement of the sulfide corrosion resistance. These effects are obtained by making the concentration of Mg in the film over 0.5 at%. Preferably, the concentration is 1 at% or more. Excessive rise of Mg conversely obstructs the above-mentioned film formation, so the upper limit is made less than 5 at%. Preferably the concentration is 3 at% or less.

More preferably, it is effective to concentrate Si and Ti in the surface film and base iron interface to raise the sulfide corrosion resistance. To obtain these effects, the total amount of the Si and Ti in the surface film (below, indicated as "Si+Ti") is made over 5 at%. Preferably, the Si+Ti concentration is 8 at% or more. More preferably, the two elements are contained combined. Excessive increase of the Si+Ti concentration obstructs the above-mentioned film formation, so the upper limit is made 15 at%. Preferably, the concentration is 12 at% or less, more preferably 10 at% or less.

Further, the amount of S of the surface film is made 3 at% or less with respect to the total amount of all cations except O, C, and N so as to suppress the start of corrosion due to hydrogen sulfide at a high temperature. Preferably, it is 2 at% or less, more preferably less than 1 at%. The lower limit of the amount of S is not particularly defined, but non-detection (= zero).

The composition of the surface film and the states of presence of Al, Mg, S, Si, Ti, Cr, and Fe can be investigated by X-ray photoelectron spectroscopy. In the case of an X-ray source of mono-AlKα rays and an incident X-ray energy of 1486.6 eV, the states of these elements in the surface film can be confirmed by detection of the spectrums near the following binding energies. The X-ray detection angle is made 90°. A depth of about 5 nm from the surface can be analyzed nondestructively.
Al2s: 119eV, Mgls: 1303eV, S2p: 160eV
Si2p: 153eV, Ti2p3/2: 456 to 458eV,
Cr2p3/2: 576eV Fe2p3/2: 710eV
Here, the atomic concentrations of the elements can be found by measuring integrated intensities of the spectrums and converting the measured integrated intensities to the cations of the elements other than C and O and N light elements.

The film thickness can be found by measuring the profile of O by conducting Ar sputtering using the XPS analysis apparatus and determining the half value where the intensity of O becomes a half value.

The Al-containing ferritic stainless steel of the present invention is provided with a mainly Al surface film having the above composition and thickness, so is excellent in sulfide corrosion resistance in H₂S. For example, even if the steel is heat treated in a 2%H₂S-bal.N₂ simulated atmosphere of the sulfide process of a compound-type thin film solar cell at 700°C for 1 hour, no corrosion is observed or no steel base material sloughs off.

(III) The method for production will be explained below:
To form the surface film described in (II) on the steel of the composition described in (I), the steel is preferably heat treated under the following conditions. In the materials, the steel sheets involve thin sheets, foil, and medium thick sheets. The method for production is not particularly limited. Here, "thin sheets" cover thicknesses of 0.2 mm or more, "foil" cover thicknesses of 0.02 to 0.2 mm, and "medium thick sheets" cover thicknesses of 6 mm or more. The surface roughness of the steel is not particularly limited. The BA, 2B, 2D, No. 4, polishing, etc. based on the JIS are sufficient.

In the stainless steel of the present invention, the steel sheet involves mainly cold rolled and annealed sheet obtained by cold rolling a hot rolled steel strip with followed by annealing or without annealing, then descaling, then bright annealing the steel strip for finish annealing or descaling the steel strip as necessary. The finish annealing is preferably made to be between 700 and 1100°C. If less than 700°C, the softening and recrystallization of the steel become insufficient and the desired material characteristics of the sometimes may not be obtained. On the other hand, if over 1100°C, coarse grains result and sometimes impair the toughness and ductility of the steel.

To form the above-mentioned surface film mainly comprising Al and raised in content of Mg, it is effective to perform bright annealing in a low dew point atmosphere containing hydrogen gas after cold working. The atmospheric gas of the bright annealing is made one which contains hydrogen gas in 50 vol% or more and a balance of an inert gas so as to suppress the oxidation of Cr and Fe and cause the selective oxidation of the above elements on the surface. The dew point of the atmospheric gas is -40°C or less. The content of the hydrogen gas is preferably 80 vol% or more, more preferably 90 vol% or more. The inert gas of the balance is preferably the industrially inexpensive nitrogen gas, but may also be Ar gas or He gas. Further, it may contain oxygen or another gas in a range of less than 5 vol% and to the extent in which the formation of the above-mentioned surface film is promoted or not obstructed. In particular, by mixing 0.1 vol% to less than 3 vol% of oxygen gas in the above low dew point hydrogen gas atmosphere, it is possible to cause Al and Mg to selectively oxidize to promote the formation of a surface film excellent in sulfide corrosion resistance. In this case, Si and Ti may also be selectively made to oxidize.

The temperature of the bright annealing is made to be the recrystallization temperature of the steel of 700°C or more and preferably made to be 800°C or more, more preferably is made to be 850°C or more, so as to lower the dew point of the atmospheric gas. On the other hand, when the temperature of the bright annealing is over 1100°C, coarse grains result. As explained above, this is not preferable in terms of the toughness, ductility, and other qualities of the steel. The heating temperature of the steel sheet is preferably made to be 850°C to 1000°C in range. The heating time for keeping the above-mentioned temperature is preferably made within 10 minutes considering performing the bright annealing on an industrial continuous annealing line. More preferably it is made within 5 minutes. The rate of temperature rise is preferably made 10°C/sec or more, more preferably 15°C/sec or more, so as to suppress the oxidation of Fe and Cr. The upper limit of the rate of rising temperature is not particularly limited, but from the viewpoint of industrial productivity, the rate is preferably made 50°C/secor less.

If performing these bright annealing in a batch furnace, the upper limit of the heating time is not particularly prescribed. For example, the conditions may also be made 700°C for 24 hours. Here, in order to form the above-mentioned surface film and to achieve excellent gas corrosion resistance, in the method for producing the stainless steel according to the present invention, the bright annealing is not limited to these conditions.

To reduce the amount of S to obtain a film composition of the present invention optimal for the sulfide corrosion resistance, after bright annealing, it is preferable to electrolytically pickle the steel in a nitric acid aqueous solution. The concentration of nitric acid is preferably 3 to 20 wt% in range to remove by electrolysis the S deposited on the surface. If the concentration of nitric acid is less than 3%, the effect of electrolytic pickling is difficult to obtain. On the other hand, if the concentration of nitric acid exceeds 20%, the Cr will increasingly concentrate at the surface film leading to obstruction of formation of the above-mentioned surface film. The nitric acid electrolysis is preferably performed by an industrial electrolytic pickling apparatus. For example, it is also possible to perform a water washing or dilute sulfuric acid electrolytic pickling or other cleaning process in a facility provided with a pretreatment tank or a plurality of electrolytic pickling tanks, then perform the nitric acid electrolysis. The current density and temperature of the nitric acid electrolysis are not particularly limited so long as they do not impair the film composition.

### Examples

Below, examples of the present invention will be explained.

Ferritic stainless steels having the compositions of Table 1 were smelted, hot rolled and annealed, then cold rolled to obtain thickness 0.05 to 0.5 mm foils or thin sheets. Here, the components of the steels were made to fall into the ranges defined by the present invention or made to fall outside the ranges defined by the present invention. The cold rolled steel sheets were all final annealed by bright annealing (BA) in the range of 800 to 1000°C where recrystallization is completed. Furthermore, some of the cold rolled steel sheets were treated by nitric acid electrolytic pickling in an 8% nitric acid aqueous solution and the Steel Nos. 1 to 17 were obtained. The bright annealing conditions and pickling conditions of these steel sheets are shown in Table 2.

The bright annealing was performed in an atmosphere containing hydrogen gas in 80 to 100 vol% and having a balance of nitrogen gas at 700 to 1050°C and with an atmospheric gas dew point of -45 to -65°C in range. The heating time was made 1 to 3 minutes. The bright annealing of some steel sheets was performed in an atmosphere in which less than 3% of oxygen gas was mixed in. Further, the bright annealing of some steel sheets was made heat treatment by a batch furnace in the hydrogen gas atmosphere for 60 minutes. The surface films of the prepared steel sheets were analyzed by the above-mentioned XPS method to determine the compositions of Al, Mg, S, Cr, and Fe in the films. The film thicknesses were made the half values of O by the Ar sputtering method.

The steel sheets of Table 2 were heat treated in a 2%H₂S-bal.N₂ atmosphere at 700°C for 1 hour to evaluate the sheet sheets of Table 2 for sulfide corrosion resistance. The sulfide corrosion resistances of the steel sheets were evaluated by visual determination as "Very good" in the state where no corrosion could be observed, "Good" in the state where light corrosion which did not cause the surface of the steel sheet to slough off was observed, and "Poor" in the state where corrosion which caused the surface of the steel sheet to slough off was observed. The sulfide corrosion resistance targeted by the present invention is "Very good" to "Good".

### Table 1

**Table 1. Composition (mass%)**

| Steel | C | Si | Mn | P | S | Cr | Al | N | Ti | Mg | Others |
|---|---|---|---|---|---|---|---|---|---|---|---|
| A | 0.028 | 1.80 | 0.15 | 0.030 | 0.0090 | 20.8 | 2.40 | 0.025 | 0.250 | 0.0030 | |
| B | 0.008 | 0.45 | 0.25 | 0.019 | 0.0003 | 17.2 | 1.80 | 0.011 | 0.150 | 0.0015 | |
| C | 0.011 | 0.50 | 0.90 | 0.025 | 0.0008 | 18.2 | 2.10 | 0.010 | 0.150 | 0.0005 | Ga: 0.0035 |
| D | 0.006 | 0.45 | 0.21 | 0.019 | 0.0006 | 17.9 | 1.90 | 0.006 | 0.170 | 0.0030 | Ga: 0.0015, B: 0.0010, Sn: 0.012 |
| E | 0.003 | 1.10 | 0.30 | 0.038 | 0.0003 | 13.5 | 2.30 | 0.010 | 0.180 | 0.0035 | Mo: 1.5, V: 0.15, La: 0.01, Ca: 0.005 |
| F | 0.005 | 0.90 | 1.80 | 0.027 | 0.0019 | 16.9 | 1.65 | 0.012 | 0.380 | 0.0090 | Y: 0.01, Zr: 0.01 |
| G | 0.015 | 0.55 | 0.35 | 0.025 | 0.0002 | 19.2 | 1.60 | 0.015 | 0.040 | 0.0032 | Ni: 0.3, Cu: 0.4, Nb: 0.25, Ga: 0.0005 |
| H | 0.013 | 0.15 | 0.25 | 0.012 | 0.0005 | 18.1 | 1.70 | 0.015 | 0.170 | 0.0021 | W: 0.1, Ga: 0.004 |
| I | 0.005 | 0.15 | 0.50 | 0.027 | 0.0019 | 17.1 | 1.55 | 0.018 | 0.250 | 0.0003 | |
| J | 0.004 | 0.25 | 0.14 | 0.022 | 0.0007 | 12.7 | 1.60 | 0.010 | 0.110 | 0.0019 | Sn: 0.02 |
| K | 0.015 | 0.32 | 2.20 | 0.020 | 0.0007 | 16.3 | 1.60 | 0.016 | 0.150 | 0.0018 | |
| L | 0.011 | 0.36 | 0.20 | 0.020 | 0.0105 | 16.2 | 1.70 | 0.015 | 0.250 | 0.0015 | |
| M | 0.033 | 0.35 | 0.35 | 0.030 | 0.0007 | 13.2 | 1.50 | 0.031 | 0.090 | 0.0020 | Sn: 0.01 |
| N | 0.025 | 0.25 | 0.35 | 0.030 | 0.0007 | 18.0 | 1.50 | 0.025 | - | 0.0015 | Nb: 0.25 |
| O | 0.005 | 0.90 | 1.80 | 0.027 | 0.0019 | 16.9 | 1.65 | 0.012 | 0.380 | 0.0110 | Sb: 0.01, Ni: 0.3 |
| P | 0.009 | 0.42 | 0.25 | 0.019 | 0.0003 | 16.2 | 1.60 | 0.012 | 0.590 | 0.0018 | |
| Q | 0.012 | 0.38 | 0.32 | 0.021 | 0.0005 | 17.5 | 1.40 | 0.011 | 0.150 | 0.0020 | |

| | | | | | | | | | | | |
|---|---|---|---|---|---|---|---|---|---|---|---|
| (Note 1) Underlines mean that chemical composition is outside the present invention. | | | | | | | | | | | |

Table 2 shows together the surface films and results of evaluation of the sulfide corrosion resistance. Nos. 1 to 5 and 7 to 8 have compositions and surface films prescribed in the present invention and achieve sulfide corrosion resistance in H₂S. Nos. 3, 4, 7, and 8 include the optimal total contents of the trace amounts of Mg and Ga elements, have the most optimal Al concentrations of 80% or more in the surface films, and satisfy S<1%, so exhibit remarkable sulfide corrosion resistance and were evaluated as "Very good". Here, No. 3 was remarkably increased in concentration of Al in the film due to the effect of addition of Ga. Further, Nos. 7 and 8 contained trace amounts of oxygen in the bright annealing atmosphere and remarkably rose in concentration of Al in the film. Nos. 1, 2, 5, and 6 had the film compositions and sulfide corrosion resistance targeted by the present invention and were evaluated as "Good". Further, Nos. 5, 7, and 8 were decreased in concentration of S in the film by virtue of nitric acid electrolysis after bright annealing.

Steel Nos. 9 to 17 have steel compositions outside those prescribed in the present invention. Even if performing the bright annealing prescribed in the present invention, the composition of the film of the present invention was not formed, the targeted sulfide corrosion resistance was not obtained, and the steel was evaluated as "Poor". Note that, for the steel A, not bright annealing, but annealing and pickling were performed, whereupon the surface film of the present invention was not formed and the sulfide corrosion resistance was "Poor".

### Table 2

**Table 2. Surface Film and Results of Evaluation of Sulfide Corrosion Resistance**

| No. | Steel | Sheet thickness mm | Bright annealing | | | | Nitric acid electro-lysis | Thickness (nm) and composition (at%) of surface film | | | | | | Sulfide corrosion resistance | Remarks |
|---|---|---|---|---|---|---|---|---|---|---|---|---|---|---|---|
| | | | H₂ gas% | O₂ gas% | Temp. °C | Time min | | Thick-ness nm | Al | Cr | Fe | Mg | S | | |
| 1 | A | 0.30 | 95 | 0 | 1050 | 3 | None | 25 | 72 | 9 | 4 | 1.7 | 3.3 | Good | Inv. ex. |
| 2 | B | 0.10 | 90 | 0 | 700 | 60 | None | 13 | 77 | 7 | 6 | 0.8 | 3.2 | Good | Inv. ex. |
| 3 | C | 0.15 | 95 | 0 | 920 | 1 | None | 8 | 85 | 4 | 3 | 0.6 | 1.1 | Very good | Inv. ex. |
| 4 | D | 0.30 | 90 | 0 | 920 | 1 | None | 7 | 82 | 4 | 4 | 1.2 | 0.8 | Very good | Inv. ex. |
| 5 | E | 0.50 | 85 | 0 | 880 | 3 | Yes | 10 | 66 | 8 | 9 | 2.8 | 0.2 | Good | Inv. ex. |
| 6 | F | 0.20 | 80 | 0 | 980 | 2 | None | 8 | 65 | 8 | 5 | 4.5 | 1.5 | Good | Comp. ex. |
| 7 | G | 0.05 | 95 | 1.5 | 1020 | 2 | Yes | 15 | 86 | 4 | 3 | 1.0 | 0.0 | Very good | Inv. ex. |
| 8 | H | 0.35 | 85 | 0.3 | 970 | 3 | Yes | 13 | 87 | 3 | 1 | 0.8 | 0.2 | Very good | Inv. ex. |
| 9 | I | 0.45 | 80 | 0 | 850 | 2 | None | 6 | 70 | 10 | 10 | 0.0 | 4.0 | Poor | Comp. ex. |
| 10 | J | 0.40 | 80 | 0 | 920 | 2 | None | 7 | 60 | 8 | 21 | 0.8 | 4.2 | Poor | Comp. ex. |
| 11 | K | 0.35 | 80 | 0 | 930 | 1 | None | 5 | 60 | 9 | 16 | 1.5 | 1.5 | Poor | Comp. ex. |
| 12 | L | 0.50 | 80 | 0 | 920 | 3 | None | 7 | 65 | 9 | 18 | 0.8 | 1.2 | Poor | Comp. ex. |
| 13 | M | 0.15 | 80 | 0 | 980 | 2 | None | 3 | 61 | 10 | 20 | 0.8 | 2.2 | Poor | Comp. ex. |
| 14 | N | 0.25 | 90 | 0 | 930 | 1 | None | 5 | 68 | 15 | 8 | 0.8 | 3.2 | Poor | Comp. ex. |
| 15 | O | 0.25 | 90 | 0 | 930 | 1 | None | 5 | 60 | 9 | 9 | 6.0 | 3.0 | Poor | Comp. ex. |
| 16 | P | 0.25 | 90 | 0 | 930 | 1 | None | 5 | 65 | 5 | 10 | 0.8 | 2.2 | Poor | Comp. ex. |
| 17 | Q | 0.35 | 80 | 0 | 970 | 2 | None | 7 | 60 | 13 | 13 | 0.9 | 3.1 | Poor | Comp. ex. |

| | | | | | | | | | | | | | | | |
|---|---|---|---|---|---|---|---|---|---|---|---|---|---|---|---|
| (Note 1) Gas corrosion resistance: Very good: No corrosion, Good: light corrosion (no metal sloughing), Poor: corrosion leading to metal sloughing (Note 2) Underlines mean composition of film is outside the present invention. (Note 3) No. 6 and No. 11 contain Mn in the films thereof, so the total content of Al, Cr, Fe, Mg, Si, Ti, and S becomes smaller than 100%. | | | | | | | | | | | | | | | |

In view of the above results, in order to increase sulfide corrosion resistance of the ferritic stainless steel having less than 3% of Al, it is necessary to satisfy the ranges of Al, Cr, Fe, and Mg contents in the films prescribed in the present invention. Here, in order to raise the sulfide corrosion resistance, it is effective to raise the concentration of Al to 80% or more and to decrease the concentration of S to less than 1 %. It is clear that for suitably controlling the composition of the film, it is more effective to make 0.11≥Mg+Ga>0.002% and introduce a slight amount of oxygen into the bright annealing atmosphere, and conduct nitric acid electrolysis after bright annealing.

### Industrial Applicability

According to the present invention, it is possible to produce Al-containing ferritic stainless steel which is provided with sulfide corrosion resistance without relying on surface treatment such as coating or plating and without addition of 3% or more of Al and the Al-containing ferritic stainless steel is optimal for a CIS-based solar cell substrate which is to be exposed to hydrogen sulfide gas in a film-forming process etc.

## Claims

1. Al-containing ferritic stainless steel comprising, by mass%, C: 0.03% or less, Si: 2% or less, Mn: 1% or less, Cr: 13 to 21%, P: 0.05% or less, S: 0.01% or less, Zn: 500ppm or less, Bi: 100ppm or less, Pb: 100ppm or less, Se: 100ppm or less, H: 100ppm or less, Ta: 500ppm or less, Al: 1.5 to 2.5%, Ti: 0.03 to 0.5%, N: 0.03% or less, and Mg: 0.0005 to 0.01%; optionally Ga: 0.1% or less, and optionally one or more of Ni: 1% or less, Cu: 1% or less, Mo: 2% or less, Nb: 0.5% or less, V: 0.5% or less, Sn: 0.2% or less, Sb: 0.2% or less, W: 1% or less, Zr: 0.5% or less, Co: 0.5% or less, B: 0.005% or less, Ca: 0.005% or less, La: 0.1% or less, Y: 0.1% or less, Hf: 0.1% or less, and REM: 0.1% or less; and a balance of Fe and unavoidable impurities, the stainless steel having at the surface thereof a film of a film thickness of 3 nm to 100 nm containing Al: over 60 at%, Cr: less than 10 at%, Fe: less than 10 at%, and Mg: over 0.5 at% and less than 5 at% with respect to a total amount of all cations except C, O, and N, wherein the surface film further contains S: 3 at% or less with respect to the total amount of all cations except O, C, and N, and wherein
a composition of the surface film and amounts of cations of Al, Mg, S, Cr, and Fe and the film thickness are determined by X-ray photoelectron spectroscopy utilizing the method and procedure as described in the description.

2. The Al-containing ferritic stainless steel according to claim 1, wherein the stainless steel contains, by mass%, Ga: 0.1% or less and has a total amount of an Mg content and Ga content of over 0.002% to 0.11%.

3. The Al-containing ferritic stainless steel according to claim 1 or 2, wherein the stainless steel contains, by mass%, one or more of Ni: 1% or less, Cu: 1% or less, Mo: 2% or less, Nb: 0.5% or less, V: 0.5% or less, Sn: 0.2% or less, Sb: 0.2% or less, W: 1% or less, Zr: 0.5% or less, Co: 0.5% or less, B: 0.005% or less, Ca: 0.005% or less, La: 0.1% or less, Y: 0.1% or less, Hf: 0.1% or less, and REM: 0.1% or less.

4. A method for producing Al-containing ferritic stainless steel comprising heat treating stainless steel having a composition of any one of claims 1 to 3 in an atmosphere containing hydrogen gas in a temperature range of 700 to 1100°C so as to form the surface film according to claim 1 on the surface of the stainless steel, wherein the atmosphere containing hydrogen gas contains 50 vol% or more of hydrogen gas, less than 5 vol% of oxygen or another gas and a balance of an inert gas, and wherein the dew point of the atmosphere is -40°C or less.

5. The method for producing Al-containing ferritic stainless steel according to claim 4 further comprising electrolytic pickling of the stainless steel in a 3 to 20 wt% nitric acid aqueous solution after the heat treatment in the atmosphere containing hydrogen gas.

6. Use of the Al-containing ferritic stainless steel according to any one of claims 1 to 3 as a solar cell substrate.

## Patentansprüche

1. Al-haltiger ferritischer Edelstahl umfassend, in Massen-%, C: 0,03% oder weniger, Si: 2% oder weniger, Mn: 1% oder weniger, Cr: 13 bis 21%, P: 0,05% oder weniger, S: 0,01% oder weniger, Zn: 500ppm oder weniger, Bi: 100ppm oder weniger, Pb: 100ppm oder weniger, Se: 100ppm oder weniger, H: 100ppm oder weniger, Ta: 500ppm oder weniger, Al: 1,5 bis 2,5%, Ti: 0,03 bis 0,5%, N: 0,03% oder weniger, und Mg: 0,0005 bis 0,01%; gegebenenfalls Ga: 0,1% oder weniger, und gegebenenfalls eines oder mehrere von Ni: 1% oder weniger, Cu: 1% oder weniger, Mo: 2 % oder weniger, Nb: 0,5 % oder weniger, V: 0,5 % oder weniger, Sn: 0,2 % oder weniger, Sb: 0,2 % oder weniger, W: 1% oder weniger, Zr: 0,5 % oder weniger, Co: 0,5% oder weniger, B: 0,005% oder weniger, Ca: 0,005% oder weniger, La: 0,1% oder weniger, Y: 0,1% oder weniger, Hf: 0,1 % oder weniger, und REM: 0,1 % oder weniger; und einem Rest aus Fe und unvermeidbaren Verunreinigungen, wobei der Edelstahl an seiner Oberfläche einen Film mit einer Filmdicke von 3 nm bis 100 nm aufweist, enthaltend Al: mehr als 60 at%, Cr: weniger als 10 at%, Fe: weniger als 10 at% und Mg: mehr als 0,5 at% und weniger als 5 at% bezogen auf eine Gesamtmenge aller Kationen außer C, O und N, wobei der Oberflächenfilm ferner S: 3 at% oder weniger enthält, bezogen auf die Gesamtmenge aller Kationen außer O, C und N, und wobei
eine Zusammensetzung des Oberflächenfilms und Mengen an Kationen von Al, Mg, S, Cr und Fe sowie die Filmdicke durch Röntgen-Photoelektronenspektroskopie unter Verwendung der in der Beschreibung beschriebenen Methode und Vorgehensweise bestimmt werden.

2. Der Al-haltige ferritische Edelstahl nach Anspruch 1, wobei der Edelstahl enthält, in Massen-%, Ga: 0,1% oder weniger und eine Gesamtmenge eines Mg-Gehalts und Ga-Gehalts von über 0,002% bis 0,11% aufweist.

3. Der Al-haltige ferritische Edelstahl nach Anspruch 1 oder 2, wobei der Edelstahl eines oder mehrere, in Massen-%, von Ni: 1% oder weniger, Cu: 1% oder weniger, Mo: 2% oder weniger, Nb: 0,5% oder weniger, V: 0,5% oder weniger, Sn: 0,2% oder weniger, Sb: 0,2% oder weniger, W: 1% oder weniger, Zr: 0,5% oder weniger, Co: 0,5% oder weniger, B: 0,005% oder weniger, Ca: 0,005% oder weniger, La: 0,1% oder weniger, Y: 0,1% oder weniger, Hf: 0,1% oder weniger, und REM: 0,1% oder weniger, enthält.

4. Ein Verfahren zur Herstellung von Al-haltigem ferritischem Edelstahl, umfassend das Wärmebehandeln von Edelstahl mit einer Zusammensetzung nach einem der Ansprüche 1 bis 3 in einer Wasserstoffgas enthaltenden Atmosphäre in einem Temperaturbereich von 700 bis 1100°C, um den Oberflächenfilm nach Anspruch 1 auf der Oberfläche des Edelstahls zu bilden, wobei die Wasserstoffgas enthaltende Atmosphäre 50 Vol% oder mehr Wasserstoffgas, weniger als 5 Vol% Sauerstoff oder eines anderen Gases und als Rest ein Inertgas enthält und wobei der Taupunkt der Atmosphäre -40°C oder weniger beträgt.

5. Das Verfahren zur Herstellung von Al-haltigem ferritischem Edelstahl nach Anspruch 4, ferner umfassend das elektrolytische Beizen des Edelstahls in einer 3 bis 20 Gew.-%igen wässrigen Salpetersäurelösung nach der Wärmebehandlung in einer Wasserstoffgas enthaltenden Atmosphäre.

6. Verwendung des Al-haltigen ferritischen Edelstahls nach einem der Ansprüche 1 bis 3 als Solarzellen-Substrat.

## Revendications

1. Acier inoxydable ferritique contenant de l'Al comprenant, en % en masse, C : 0,03 % ou moins, Si : 2 % ou moins, Mn : 1 % ou moins, Cr : 13 à 21 %, P : 0,05 % ou moins, S : 0,01 % ou moins, Zn : 500 ppm ou moins, Bi : 100 ppm ou moins, Pb : 100 ppm ou moins, Se : 100 ppm ou moins, H : 100 ppm ou moins, Ta : 500 ppm ou moins, Al : 1,5 à 2,5 %, Ti : 0,03 à 0,5 %, N : 0,03 % ou moins, et Mg : 0,0005 à 0,01 % ; éventuellement Ga : 0,1 % ou moins, et éventuellement un ou plusieurs parmi Ni : 1 % ou moins, Cu : 1 % ou moins, Mo : 2 % ou moins, Nb : 0,5 % ou moins, V : 0,5 % ou moins, Sn : 0,2 % ou moins, Sb : 0,2 % ou moins, W : 1 % ou moins, Zr : 0,5 % ou moins, Co : 0,5 % ou moins, B : 0,005 % ou moins, Ca : 0,005 % ou moins, La : 0,1 % ou moins, Y : 0,1 % ou moins, Hf : 0,1 % ou moins, et REM: 0,1 % ou moins, et un reste consistant en Fe et des impuretés inévitables,
l'acier inoxydable ayant, au niveau de sa surface, un film ayant une épaisseur de film de 3 nm à 100 nm, contenant Al : plus de 60 % atomiques, Cr : moins de 10 % atomiques, Fe : moins de 10 % atomiques, et Mg : plus de 0,5 % atomique et moins de 5 % atomiques par rapport à une quantité totale de tous les cations à l'exception de C, O, et N, dans lequel le film de surface contient en outre S : 3 % atomiques ou moins par rapport à la quantité totale de tous les cations à l'exception de O, C, et N, et dans lequel une composition du film de surface et les quantités des cations Al, Mg, S, Cr et Fe, et l'épaisseur du film, sont déterminées par spectroscopie photoélectronique aux rayons X utilisant la méthode et la procédure telles que décrites dans la description.

2. Acier inoxydable ferritique contenant de l'Al selon la revendication 1, dans lequel l'acier inoxydable contient, en % en masse, Ga : 0,1 % ou moins, et a une quantité totale de la teneur en Mg et de la teneur en Ga de plus de 0,002 % à 0,11 %.

3. Acier inoxydable ferritique contenant de l'Al selon la revendication 1 ou 2, dans lequel l'acier inoxydable contient, en % en masse, un ou plusieurs parmi Ni : 1 % ou moins, Cu : 1 % ou moins, Mo : 2 % ou moins, Nb : 0,5 % ou moins, V : 0,5 % ou moins, Sn : 0,2 % ou moins, Sb : 0,2 % ou moins, W : 1 % ou moins, Zr : 0,5 % ou moins, Co : 0,5 % ou moins, B : 0,005 % ou moins, Ca : 0,005 % ou moins, La : 0,1 % ou moins, Y : 0,1 % ou moins, Hf : 0,1 % ou moins, et REM : 0,1 % ou moins.

4. Méthode pour produire un acier inoxydable ferritique contenant de l'Al, comprenant le traitement à la chaleur d'un acier inoxydable ayant une composition de l'une quelconque des revendications 1 à 3 dans une atmosphère contenant de l'hydrogène gazeux dans une plage de température allant de 700 à 1100°C de façon à former un film de surface selon la revendication 1 sur la surface de l'acier inoxydable, dans lequel l'atmosphère contenant de l'hydrogène gazeux contient 50 % en volume ou plus d'hydrogène gazeux, moins de 5 % en volume d'oxygène ou d'un autre gaz, et un gaz inerte pour le reste, et dans laquelle le point de rosée de l'atmosphère est de -40°C ou moins.

5. Méthode pour produire un acier inoxydable ferritique contenant de l'Al selon la revendication 4, comprenant en outre le décapage électrolytique de l'acier inoxydable dans une solution aqueuse à 3 à 20 % en poids d'acide nitrique après le traitement à la chaleur dans l'atmosphère contenant de l'hydrogène gazeux.

6. Utilisation de l'acier inoxydable ferritique contenant de l'Al de l'une quelconque des revendications 1 à 3 en tant que substrat de cellule solaire.
